# EUROPEAN PATENT APPLICATION

(11) **EP 4 826 929 A1**
(43) Date of publication of application: **21.10.2026**
(21) Application number: 25192886.7
(22) Date of filing: 30.07.2025
(51) Int. Cl.: H01S 5/227, H01S 5/20, H01S 5/22, H01S 5/32, H01S 5/323

(54) **SINGLE MODE BURIED HETEROSTRUCTURE SEMICONDUCTOR LASERS**

(30) Priority: 17.04.2025 US 202519182211
(71) Applicant: II-VI Delaware, Inc., Wilmington, DE 19890 (US)
(72) Inventor: FENG, Tao, Wilmington, 19890 (US); VERMA, Ashish, Wilmington, 19890 (US); SUDO, Tsurugi, Wilmington, 19890 (US); LIN, Yong, Wilmington, 19890 (US); DALIDA, Nicholas, Wilmington, 19890 (US); WON, Jon, Wilmington, 19890 (US)
(74) Representative: Schmidt, Christian

(57) **Abstract**

A single-mode laser includes a mesa, lateral cladding, upper cladding, and lower cladding. The mesa includes an active region configured to emit light in response to an applied current and an upper waveguide layer. The lateral cladding laterally flanks the active region and the upper waveguide layer. The lower waveguide layer laterally extends under the lateral cladding and causes higher-order modes of the light to leak past the lateral cladding to at least partially contribute to the higher-order modes not reaching a lasing threshold. The upper cladding, the lower cladding, and lateral cladding sufficiently confine a fundamental mode of the light to reach a lasing threshold and generate a lasing light.

## Description

### TECHNICAL FIELD

Aspects of the present disclosure relate to semiconductor lasers and more specifically to buried heterostructure semiconductor lasers.

### BACKGROUND

Conventional buried heterostructure (BH) laser designs generally provide a low lasing threshold, low current spreading, and good thermal dissipation while being compatible with flip-chip bonding. However, when used to implement a single-mode distributed feedback (DFB) laser, conventional buried heterostructure (BH) laser designs require a narrow mesa to ensure that only the fundamental lateral mode exists in the waveguide. More specifically, buried heterostructure (BH) laser designs used in telecommunication and data communication systems require a mesa width of 2 µm or possibly less depending on the lasing wavelength and materials used to implement the design.

However, narrow mesas introduce high series resistance and high thermal resistance. As such, conventional buried heterostructure (BH) designs are not favored for high-power operation due to their high series resistance and thermal resistance. Further limitations and disadvantages of conventional and traditional approaches will become apparent to one of skill in the art, through comparison of such approaches with some aspects of the present disclosure as set forth in the remainder of the present application with reference to the drawings.

### BRIEF SUMMARY OF THE DISCLOSURE

Shown in and/or described in connection with at least one of the figures, and set forth more completely in the claims, are single-mode buried heterostructure (BH) lasers with a wider mesa width than conventional single-mode buried heterostructure (BH) laser designs.

These and other advantages, aspects, and novel features of the present disclosure, as well as details of illustrated embodiments thereof, will be more fully understood from the following description and drawings.

### BRIEF DESCRIPTION OF THE DRAWINGS

Various features and advantages of the present disclosure may be more readily understood with reference to the following detailed description taken in conjunction with the accompanying drawings, wherein like reference numerals designate like structural elements.
FIG. 1 depicts a cross section of an embodiment of a single-mode buried heterostructure (BH) laser in accordance with various aspects of the present disclosure.
FIG. 2A-2D depict two-dimensional optical mode distribution for a fundamental mode and higher-order modes in the single-mode buried heterostructure (BH) laser of FIG. 1.
FIG. 3A provides a graph depicting an optical confinement factor of the fundamental mode and two higher-order modes versus mesa width for an embodiment of the single-mode buried heterostructure (BH) laser of FIG. 1.
FIG. 3B provides a graph depicting threshold gain of the fundamental mode and two higher-order modes versus mesa width for an embodiment of the single-mode buried heterostructure (BH) laser of FIG. 1.
FIG. 4A-5F depicts process of forming the single-mode buried heterostructure (BH) laser of FIG. 1.
FIGS. 5A-5C depicts additional embodiments of a single-mode buried heterostructure (BH) laser in accordance with various aspects of the present disclosure.

### DESCRIPTION

The present disclosure is directed to single-mode lasers. In various embodiments, a single-mode laser may comprise a mesa and a lower waveguide layer below the mesa. The lower waveguide layer may pull or direct higher-order modes away from an active region of the mesa and ensure that such higher-order modes fail to reach a lasing threshold. In this manner, the laser may provide a stable single spatial mode of operation despite the mesa being structurally wider than mesas of conventional buried heterostructure (BH) lasers. The wider mesa may provide the single-mode laser of the present disclosure with various advantages over conventional single-mode buried heterostructure (BH) lasers. In particular, the wider mesa may provide a single mode laser with lower series resistance and/or lower thermal resistance. Such benefits may further provide single mode lasers with higher power conversion efficiency and lower power consumption. Further, such benefits may provide single mode lasers with high slope efficiency and/or high power.

The figures illustrate a general manner of construction. Descriptions and details of well-known features and techniques may be omitted to avoid unnecessarily obscuring the present disclosure. In addition, elements in the drawing figures are not necessarily drawn to scale. For example, the dimensions of some of the elements in the figures may be exaggerated relative to other elements to help improve understanding of the examples discussed in the present disclosure. The same reference numerals in different figures denote the same elements.

The term "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z".

The terms "comprises," "comprising," "includes," and/or "including," are "open ended" terms and specify the presence of stated features, but do not preclude the presence or addition of one or more other features.

The terms "first," "second," *etc.* may be used herein to describe various elements, and these elements should not be limited by these terms. These terms are only used to distinguish one element from another. Thus, for example, a first element discussed in this disclosure could be termed a second element without departing from the teachings of the present disclosure.

Unless specified otherwise, the term "coupled" may be used to describe two elements directly contacting each other or describe two elements indirectly connected by one or more other elements. For example, if element A is coupled to element B, then element A may be directly contacting element B or indirectly connected to element B by an intervening element C. Similarly, the terms "over" or "on" may be used to describe two elements directly contacting each other or describe two elements indirectly connected by one or more other elements.

Also, any numerical range recited herein is intended to include all sub-ranges subsumed therein. For example, a range of "1 to 10" is intended to include any and all sub-ranges between and including the recited minimum value of 1 and the recited maximum value of 10, that is, all sub-ranges beginning with a minimum value equal to or greater than 1 and ending with a maximum value equal to or less than 10, and all sub-ranges in-between, *e.g.,* 1 to 6.3, or 5.5 to 10, or 2.7 to 6.1.

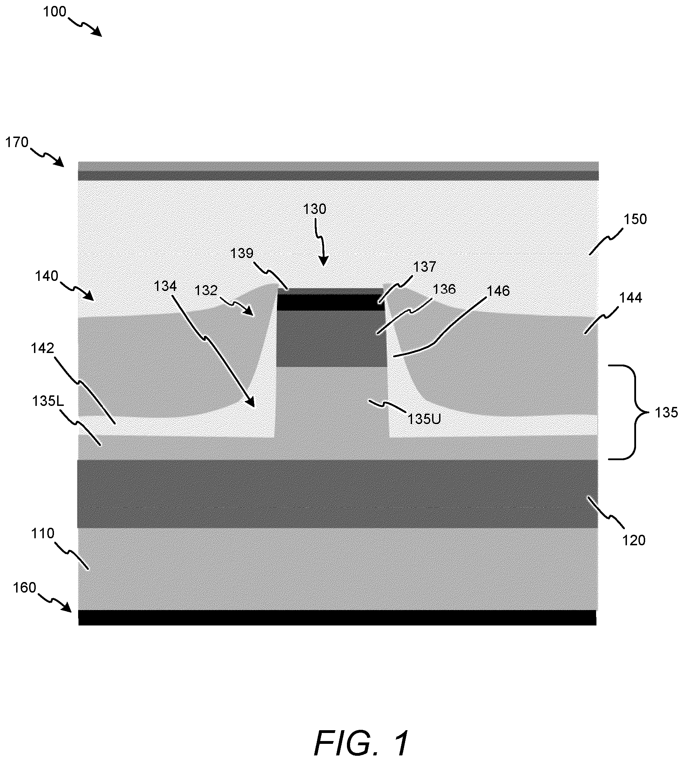

FIG. 1 depicts a cross-section of an example embodiment of a single-mode laser 100 in accordance with various aspects of the present disclosure. In particular, the cross-section of FIG. 1 is taken perpendicularly to the propagation direction of light. As shown, the laser 100 may comprise a buried heterostructure (BH) design in which a mesa and its active region *(e.g.,* a heterostructure) are buried in surrounding semiconductor. In particular, the laser 100 may include a lower cladding 110, a lower waveguide layer 120, a mesa 130, lateral cladding 140, and an upper cladding 150. The laser 100 may further include a lower electrical contact 160 below the lower cladding 110 and an upper electrical contact 170 above the upper cladding 150.

The lower cladding 110 may comprise a lower cladding top side, a lower cladding bottom side, and lower cladding lateral sides between the lower cladding top side and the lower cladding bottom side. In various embodiments, the lower cladding 110 may be provided by an appropriately doped semiconductor substrate such as an n-doped indium phosphide (InP) substrate.

As shown, the lower waveguide layer 120 may be on the lower cladding 110. In particular, the lower waveguide layer 120 may comprising a lower waveguide layer top side, a lower waveguide layer bottom side, and lower waveguide layer lateral sides between the lower waveguide layer top side and the lower waveguide layer bottom side. The lower waveguide layer bottom side may rest upon or be otherwise coupled to the lower cladding top side. In various embodiments, the lower waveguide layer 120 has a higher refractive index than the lower cladding 110. Such difference in refractive indices may cause total internal reflection of light at an interface between the lower waveguide layer 120 and the lower cladding 110 and guide such light in the lower waveguide layer 120 along the lower waveguide layer 120. In various embodiments, the lower waveguide layer 120 may comprise a semiconductor layer having a suitable index of refraction such as n-doped indium gallium arsenide phosphide (InGaAsP).

The mesa 130 may comprise a mesa upper region 132 and a mesa lower region 134. The mesa upper region 132 corresponds to the portion of the mesa 130 that is laterally flanked or confined by the lateral cladding 140. Conversely, the mesa lower region 134 corresponds to the portion of the mesa 130 that laterally extends below the lateral cladding 140 and is thus laterally unconfined by lateral cladding 140.

More specifically, the mesa 130 may comprise a mesa pedestal 135, an upper waveguide layer 136, an active region 137, and a separate confinement heterostructure (SCH) 139. The mesa pedestal 135 may be on or otherwise coupled to the lower waveguide layer 120. Moreover, the mesa pedestal 135 may have a lower refractive index than the lower waveguide layer 120. Such difference in refractive indices may cause total internal reflection of light at an interface between the lower waveguide layer 120 and the mesa pedestal 135 and guide such light in the lower waveguide layer 120 along the lower waveguide layer 120. In various embodiments, the mesa pedestal 135 may comprise a semiconductor layer having a suitable index of refraction such as an n-doped indium phosphide (InP) layer.

As shown, the mesa pedestal 135 may comprise a mesa pedestal lower tier 135L on the lower waveguide layer 120 and a mesa pedestal upper tier 135U on the mesa pedestal lower tier 135L. The mesa pedestal lower tier 135L may cover the lower waveguide layer top side and may extend under the lateral cladding 140. As such, the mesa pedestal lower tier 135L may provide at least a portion of the mesa lower region 134. Conversely, the mesa pedestal upper tier 135U may protrude from a top side of the mesa pedestal lower tier 135L and may be laterally flanked by the lateral cladding 140. As such, the mesa pedestal upper tier 135U may provide at least a portion of the mesa upper region 132.

The mesa pedestal lower tier 135L may be wider than the mesa pedestal upper tier 135U. As such, the mesa pedestal lower tier 135L may cover the lower waveguide layer top side and may vertically separate the lateral cladding 140 from the lower waveguide layer top side. As such, the mesa pedestal lower tier 135L may provide at least a portion of the mesa lower region 134.

The upper waveguide layer 136 may comprise an upper waveguide layer top side, an upper waveguide layer bottom side, and upper waveguide layer lateral sides between the upper waveguide layer top side and the upper waveguide layer bottom side. The upper waveguide layer bottom side may rest upon or be otherwise coupled to a mesa pedestal top side. Furthermore, the upper waveguide layer lateral sides may be laterally flanked by the lateral cladding 140. In various embodiments, the upper waveguide layer 136 has a higher refractive index than the mesa pedestal 135 and a higher refractive index than the lateral cladding 140. Such differences in refractive indices may cause total internal reflection of light at an interface between the upper waveguide layer 136 and the mesa pedestal 135 and between an interface between the upper waveguide layer 136 and the lateral cladding 140. As such, light in the upper waveguide layer 136 may be guided along the upper waveguide layer 136. In various embodiments, the upper waveguide layer 136 may comprise a semiconductor layer having a suitable index of refraction such as n-doped indium gallium arsenide phosphide (InGaAsP).

In various embodiments, one or more sides (*e.g.,* a top side) of the upper waveguide layer 136 may be etched or otherwise formed to include a diffraction grating. Per such embodiments, the laser 100 may define a distributed-feedback laser (DFB) in which the diffractive grating may act like an optical filter, causing a single wavelength to be fed back to the active region 137 and lase. In other embodiments, opposite ends of the upper waveguide layer 136 may be cleaved or otherwise provided with reflecting surfaces (*e.g.,* mirrors). Such reflective ends may form a Fabry-Pérot resonator that reflect photons propagating along the upper waveguide layer 136 several times before they lase and exit one of the ends.

The active region 137 may comprise an active region top side, and active region bottom side, and active region lateral sides. As shown, the active region lateral sides may be laterally flanked by lateral cladding 140. Thus, the active region 137 may provide at least a portion of the mesa upper region 132. Moreover, the active region bottom side may rest upon or be otherwise coupled to the upper waveguide layer 136.

The active region 137 may comprise heterostructures such as quantum wells which emit photons when pumped or driven by an electric current. In particular, the active region 137 may comprise alternating layers of compound semiconductors such as, for example, gallium arsenide, indium phosphide, gallium antimonide, and gallium nitride which may form heterostructures or double heterostructures. A lowermost layer of the active region 137 may have a lower refractive index than the upper waveguide layer 136. Such difference in refractive indices may cause total internal reflection of light at an interface between the upper waveguide layer 136 and the active region 137 and guide such light in the upper waveguide layer 136 along the upper waveguide layer 136.

Furthermore, a separate confinement heterostructure (SCH) 139 may rest upon the active region top side. The separate confinement heterostructure (SCH) 139 may have a lower refractive index than a topmost layer of the active region 137. As such, the separate confinement heterostructure (SCH) 139 may help confine light and direct photons emitted by the active region 137 toward the upper waveguide layer 136 and the lower waveguide layer 120.

As shown, the lateral cladding 140 surrounds or laterally flanks the mesa upper region 132 but does not surround or laterally flank the mesa lower region 134 or the lower waveguide layer 120. The lateral cladding 140 may provide lateral electrical confinement for a current passing vertically through the mesa 130. To this end, the lateral cladding 140 may include a p-doped semiconductor layer 142 (*e.g.,* p-doped InP) that covers the lateral sides of the mesa pedestal upper tier 135U and the top side of the mesa pedestal lower tier 135L. Further, the lateral cladding 140 may include an n-doped semiconductor region 144 that extends vertically from a point near a top side of the mesa 130 toward the mesa pedestal lower tier 135L. However, a p-doped region 146 is maintained between the lateral sides of the mesa 130 and lateral sides of the n-doped semiconductor region 144. Further, the p-doped region 146 is maintained between a top side of the mesa pedestal lower tier 135L and a bottom side of the n-doped region 144. In this manner, the lateral cladding 140 may provide a p-n junction that surrounds the n-doped, mesa confined upper region, thereby blocking, preventing, and/or otherwise substantially reducing lateral current flow from the mesa 130.

Moreover, the lateral cladding 140 may provide lateral optical confinement for light propagating along the upper waveguide layer 136. To this end, p-doped semiconductor layer 142 has a lower refractive index than the upper waveguide layer 136. Such differences in refractive indices may cause total internal reflection of light at an interface between the p-doped semiconductor layer 142 and the upper waveguide layer 136. As such, light in the upper waveguide layer 136 may be guided along the upper waveguide layer 136.

Similarly, the upper cladding 150 may provide optical confinement for light propagating along the upper waveguide layer 136. To this end, the upper cladding 150 may include a p-doped semiconductor layer *(e.g.,* p-doped InP) that covers the mesa 130 and lateral cladding 140. In particular, the upper cladding 150 has a lower refractive index than the upper waveguide layer 136. Such differences in refractive indices may cause total internal reflection of light at an interface between the upper cladding 150 and the upper waveguide layer 136. As such, light in the upper waveguide layer 136 may be guided along the upper waveguide layer 136.

Finally, the upper electrical contact 170 may cover a top side of the upper cladding 150. In various embodiments, the upper electrical contact 170 may comprise one or more semiconductor layers which are heavily p-doped and/or one or more metal layers. Similarly, the lower electrical contact 160 may cover a bottom side of the lower cladding 110. In various embodiments, the lower electrical contact 160 may comprise one or more semiconductor layers which are heavily n-doped and/or one or more metal layers. As such, electrical current may flow from the upper electrical contact 170 through the mesa 130 and its active region 137 to the lower electrical contact 160. Such current flow may cause the active region 137 to emit photons.

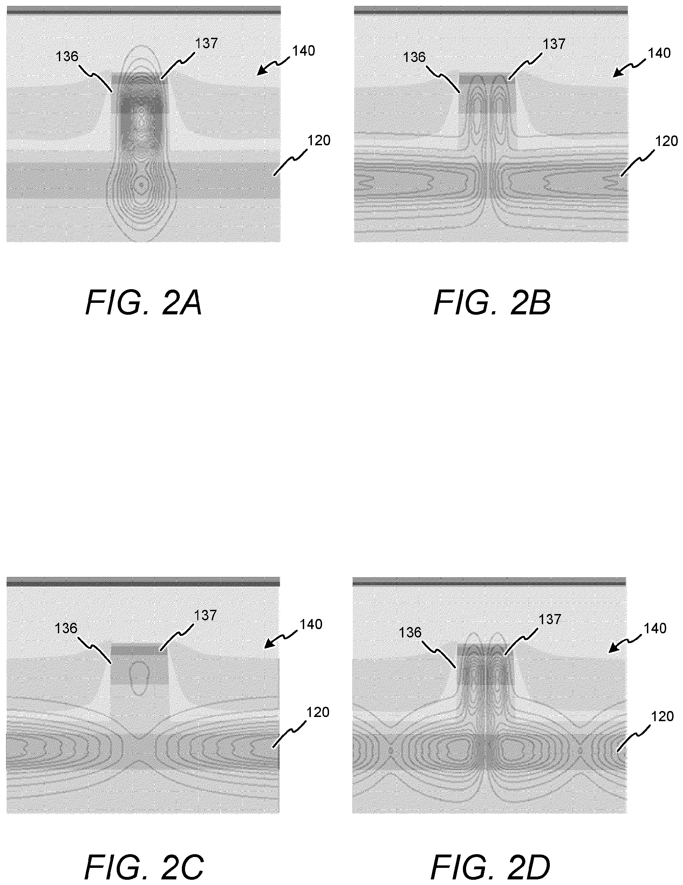

As shown in FIG. 2A-2D, the structure of the laser 100 may be tuned such that only a fundamental spatial mode of the developed light reaches the lasing threshold. For example, the thickness (*i.e.,* vertical distance between top and bottom sides) of the upper waveguide layer 136, the lower waveguide layers 120, and/or height the mesa 130 may be adjusted to ensure the fundamental spatial mode of the developed light lases while higher-order spatial modes of the developed light do not. In particular, FIG. 2A depicts an example distribution of the fundamental spatial mode of the developed light among the components of the laser 100. As shown, the fundamental spatial mode is generally vertically-confined between the lateral cladding 140. Of note, despite lateral cladding 140 being above the lower waveguide layer 120 and thus not flanking the lower waveguide layer 120, there is little to no lateral leakage of the fundamental spatial mode under the lateral cladding 140. As such, the gain obtained as a result of the fundamental spatial mode passing through the active region 137 is sufficient to exceed lateral leakage and other losses so as to reach the lasing threshold.

Conversely, the first order mode, second order mode, and third order mode respectively depicted in FIG. 2B, 2C, 2D experience significant losses. In particular, the lower waveguide layer 120 effectively pulls a significant portion of the developed light for these higher-order spatial modes below and under the lateral cladding 140. As such, these higher-order spatial modes experience significant lateral leakage. Further, only a small portion of these higher-order spatial modes passes through the active region 137. As such, the gain obtained as a result of the higher-order spatial modes passing through the active region 137 is insufficient to overcome lateral leakage and other losses so as to reach the lasing threshold for such higher-order spatial modes.

Conventionally, lasers have included a mesa with a waveguide. For such lasers, the mesa and thus its waveguide were made to have a width on the order of the optical wavelength so as to ensure only a single spatial mode is developed. The original waveband (O-band) for data communications is 1260 to 1360 nanometers (nm), the conventional waveband (C-band) for optical communications is 1530 to 1565 nm and the long waveband (L-band) for optical communications is 1565 to 1625 nm. Thus, the mesa of conventional lasers is very narrow on the order of 1.5 micrometers (µm) or less.

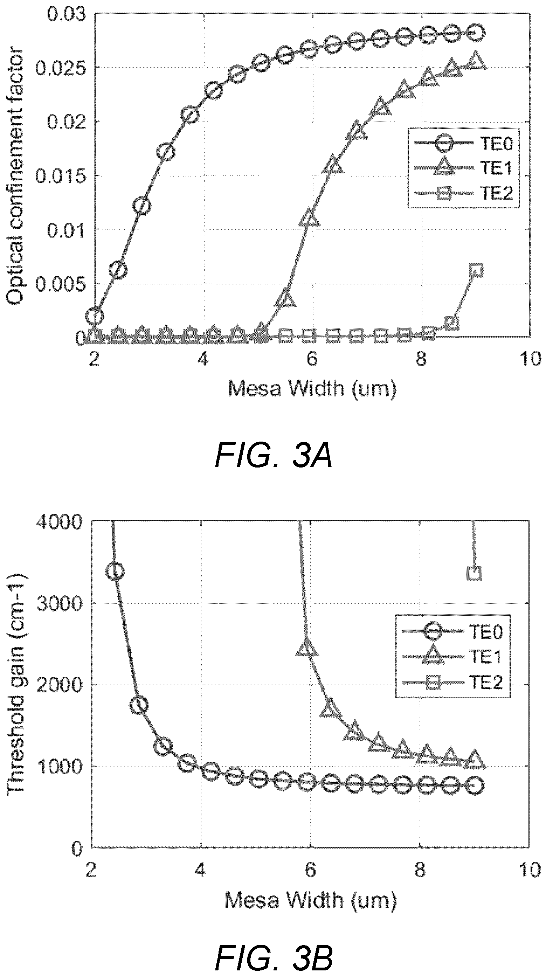

The architecture of the laser 100, however, permits a much wider mesa while still ensuring only a single spatial mode is developed. See for example FIGS. 3A and 3B. FIG. 3A depicts an optical confinement factor of various spatial modes verses mesa width for example embodiments of the laser 100. FIG. 3B depicts threshold gain for various spatial modes verses mesa width for example embodiments of the laser 100. As shown, embodiments of the laser 100 provides good optical confinement and good threshold gain for the fundamental spatial mode TE0 at mesa widths up to roughly 5 µm. Conversely, as further shown by FIGS. 3A and 3B, embodiments of the laser 100 provide poor optical confinement and/or poor threshold gain for higher-order spatial modes TE1, TE2. Thus, the laser 100 may be implemented with a mesa that is roughly 3 times wider than conventional lasers with their mesa widths of roughly 1.5 µm.

As noted above, the narrow mesa of conventional lasers presents various disadvantages which are overcome by the wider mesa of the laser 100. In various embodiments, the laser 100 may comprise a mesa 130 having a width that is greater than 2 µm, 2.5 µm, 3 µm, 4 µm, or 5 µm. In various embodiments, the laser 100 may comprise a mesa 130 having a width that is greater than 150%, 200%, 250%, or 300% of the wavelength of the lasing light.

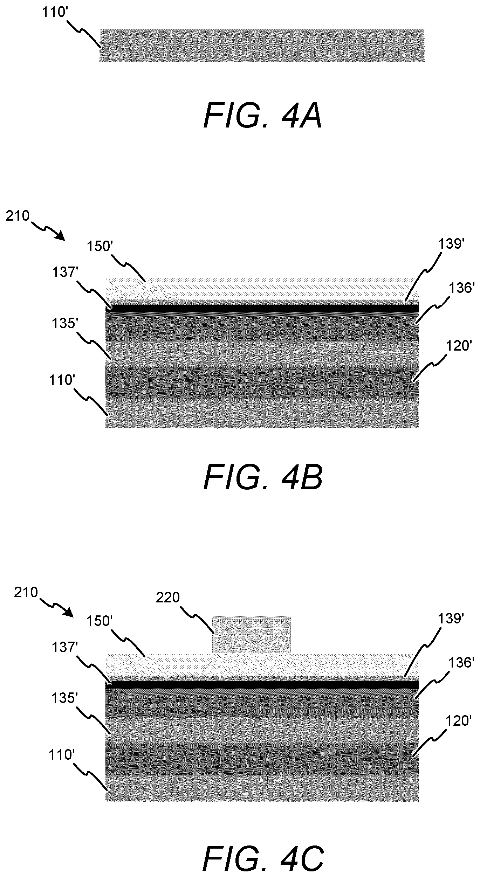

With reference to FIGS. 4A-4E, a brief description of an example process for fabricating the laser 100 is presented. As shown in FIG. 4A, the process may begin with an n-doped semiconductor substrate (*e.g.,* an n-doped InP substrate), which provides the lower cladding 110. Then, as shown in FIG. 4B, various semiconductor layers may be epitaxially grown and doped. In particular, a first n-doped semiconductor layer 120' providing the lower waveguide layer 120, a second n-doped semiconductor layer 135' providing the mesa pedestal 135, a third n-doped semiconductor layer 136' providing the upper waveguide layer 136, fourth semiconductor layers 137' providing the heterostructures of the active region 137, and a fifth p-doped semiconductor layer 139' providing the p-side separate confinement heterostructure (SCH), and a sixth p-doped semiconductor layer 150' providing a lower portion of the upper cladding 150 may be sequentially grown and doped over the substrate providing the lower cladding 110.

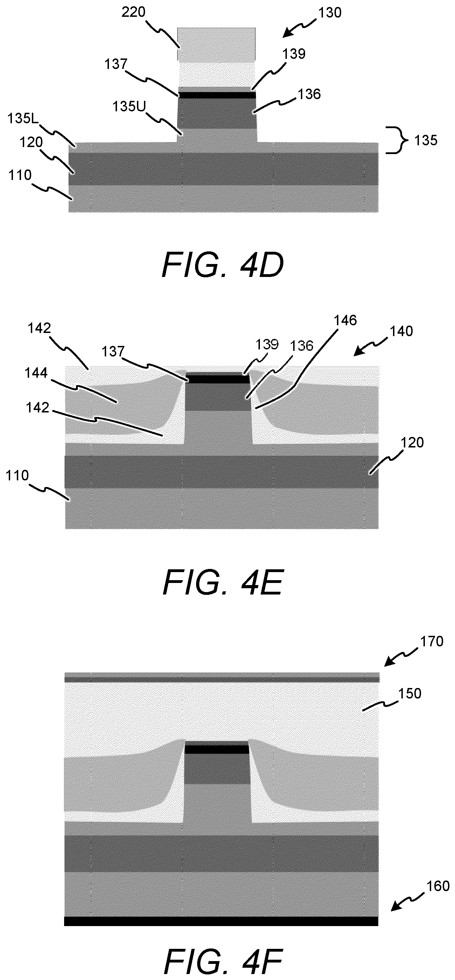

After forming the stack 210 of semiconductors layers 120', 135', 136', 137', 139', 150' on the semiconductor substrate, a hard mask 220 may be formed on a top side of the stack as shown in FIG. 4C. Then, the stack 210 of semiconductor layers may be etched to form the mesa 130 as shown in FIG. 4D. As shown, such etching may form the lateral sides of the mesa 130 and the tiered structure of the mesa pedestal 135. In particular, such etching may remove only an exposed upper portion of the second n-doped semiconductor layer 135' thus forming the tiered structure of the mesa pedestal 135.

At FIG. 4E, the lateral cladding 140 may be formed and the hard mask 220 may be removed. In particular, a p-doped semiconductor layer 142 with n-doped region 144 may be epitaxially grown on a top side of the mesa pedestal lower tier 135L such that the p-doped semiconductor layer 142 and n-doped region 144 flank the mesa 130. After forming lateral cladding 140, the hard mask 220 may be removed.

Finally, as shown in FIG. 4F, an upper portion of the upper cladding 150 may be epitaxially grown over the top side of the mesa 130 and over the top side of the lateral cladding 140. Further, an upper electrical contact 170 may be formed on a top side of the upper cladding 150. Similarly, a lower electrical contact 160 may be formed on the bottom side of the substrate 110' providing the lower cladding 110. In some embodiments, the lower electrical contact 160 may be provided prior to formation of the stack 210 of semiconductor layers.

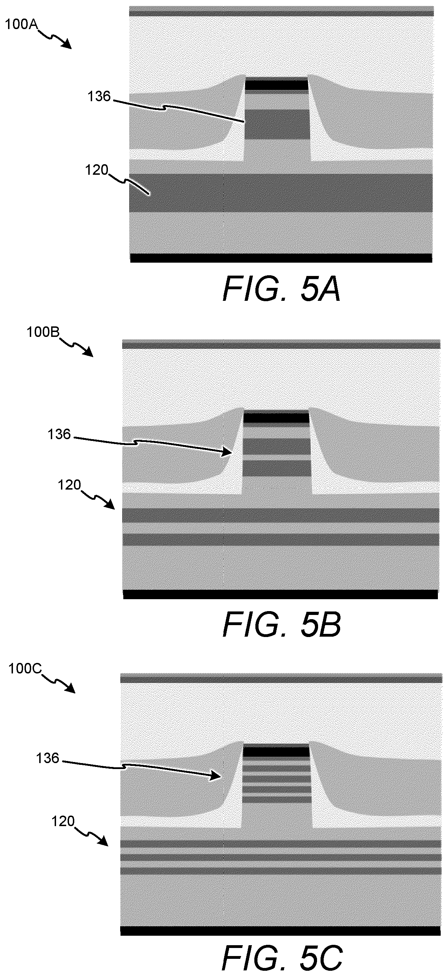

Referring now to FIGS. 5A-5C, a few variations of the laser 100 are depicted. In particular, FIG. 5A depicts a laser 100A which may be implemented in a manner similar to the laser 100 of FIG. 1. However, the upper waveguide layer 136 of the laser 100A is shifted away from the active region 137 and toward the lower waveguide layer 120, but still flanked by the lateral cladding 140 and retained within the mesa upper region 132. The laser 100A of FIG. 5A conveys that the general laser structure of the present disclosure provides some freedom in the vertical placement of the upper waveguide layer 136 within the mesa 130. Such vertical freedom may aid in tuning a specific laser implementation to lase a single mode of light having a desired wavelength.

The laser 100B of FIG. 5B depicts further options for tuning a specific laser implementation to lase a single mode of light having a desired wavelength. In particular, the laser 100B unlike the laser 100 comprises multiple lower waveguide layer 120 and multiple upper waveguide layers 136. Further, each upper waveguide layer 136 is within the mesa confined upper region and each lower waveguide layer 120 is below the mesa pedestal lower tier 135L and below the lateral cladding 140. Thus, the lateral cladding 140 may provide optical confinement for the upper waveguide layers 136 while permitting the lower waveguide layers 120 to leak higher-order modes.

Moreover, each upper waveguide layer 136 may have a different thickness. Likewise, each lower waveguide layer 120 may have a different thickness. Thus, the thickness, quantity, and vertical placement of the waveguide layers 120, 136 may be each individually tuned to achieve a laser 100B that lases a single mode of light having a desired wavelength.

Finally, the laser 100C of FIG. 5C depicts further options for tuning a specific laser implementation to lase a single mode of light having a desired wavelength. In particular, the laser 100C like the laser 100B comprises multiple upper waveguide layers 136 and multiple lower waveguide layer 120. Further, each upper waveguide layer 136 is within the mesa confined upper region and each lower waveguide layer 120 is below the mesa pedestal 135 and below the lateral cladding 140. Thus, the lateral cladding 140 may provide optical confinement for the upper waveguide layers 136 while permitting the lower waveguide layers 120 to leak higher-order modes.

As shown, the quantity of upper waveguide layers 136, however, does not equal the quantity of lower waveguide layers 120. While FIG. 5C depicts a greater number of upper waveguide layers 136 than lower waveguide layer 120, other embodiments may have a greater number of lower waveguide layers 120 than upper waveguide layers. Moreover, each upper waveguide layer 136 may have a different thickness. Likewise, each lower waveguide layer 120 may have a different thickness. Thus, the thickness, quantity, and vertical placement of the waveguide layers 120, 136 may be each individually tuned to achieve a laser 100B that lases a single mode of light having a desired wavelength.

Implementations described herein relate to a single-mode laser includes a mesa, lateral cladding, upper cladding, and lower cladding. The mesa includes an active region configured to emit light in response to an applied current and an upper waveguide layer. The lateral cladding laterally flanks the active region and the upper waveguide layer. The lower waveguide layer laterally extends under the lateral cladding and causes higher-order modes of the light to leak past the lateral cladding to at least partially contribute to the higher-order modes not reaching a lasing threshold. The upper cladding, the lower cladding, and lateral cladding sufficiently confine a fundamental mode of the light to reach a lasing threshold and generate a lasing light.

The present application claims priority of U.S. patent application US 19/182,211 filed on April 17, 2025. The entire disclosure content of this application is incorporated herein by reference for all purposes.

In the following, a set of items is disclosed. The items are numbered to facilitate referencing the features of one item in other items. The items form part of the present disclosure and could be made subject to independent and/or dependent claims irrespective of what currently is claimed in the application. We note, however, that the scope of protection is defined by the appended claims, where the following items do not constitute claims. The items are:
1. A single-mode laser, comprising:
   a mesa comprising an active region and a first upper waveguide layer;
   lateral cladding that flanks the active region and the first upper waveguide layer;
   a first lower waveguide layer the laterally extends under the lateral cladding;
   an upper cladding above the mesa; and
   a lower cladding below the mesa and the first lower waveguide layer;
   wherein the active region is configured to emit light in response to an electrical current;
   wherein the upper cladding, the lower cladding, and lateral cladding sufficiently confine a fundamental mode of the light to reach a lasing threshold and generate a lasing light; and
   wherein the first lower waveguide layer causes higher-order modes of the light to leak past the lateral cladding and at least partially contributes to the high-order modes not reaching the lasing threshold.
2. The single-mode laser of item 1, wherein a lateral width of the mesa between the lateral cladding is greater than a wavelength of the lasing light.
3. The single-mode laser of item 2, wherein the lateral width of the mesa is greater than 2.5 µm.
4. The single-mode laser of item 2, wherein the lateral width of the mesa is greater than 3 µm.
5. The single-mode laser of item 2, wherein the lateral width of the mesa is greater than 4 µm.
6. The single-mode laser of item 2, wherein the lateral width of the mesa is greater than 5 µm.
7. The single-mode laser of item 2, wherein the lateral width of the mesa is greater than 150% of the wavelength of the lasing light.
8. The single-mode laser of item 2, wherein the lateral width of the mesa is greater than 200% of the wavelength of the lasing light.
9. The single-mode laser of item 2, wherein the lateral width of the mesa is greater than 250% of the wavelength of the lasing light.
10. The single-mode laser of item 2, wherein the lateral width of the mesa is greater than 300% of the wavelength of the lasing light.
11. The single-mode laser of item 1, comprising a diffraction grating configured to reflect light of a specific wavelength toward the active region.
12. The single-mode laser of item 1, wherein the mesa includes a second upper waveguide layer.
13. The single-mode laser of item 12, wherein a thickness of the first upper waveguide layer differs from a thickness of the second upper waveguide layer.
14. The single-mode laser of item 1, comprising
   a second lower waveguide layer that laterally extends under the lateral cladding; and
   wherein the second lower waveguide layer causes higher-order modes of the light to leak past the lateral cladding and at least partially contributes to the high-order modes not reaching the lasing threshold.
15. The single-mode laser of item 14, wherein a thickness of the first lower waveguide layer differs from a thickness of the second lower waveguide layers.
16. A single-mode laser, comprising:
   an active region configured to emit light in response to an electrical current;
   one or more upper waveguide layers;
   lateral cladding that flanks the active region and the one or more upper waveguide layers;
   one or more lower waveguide layers below the one or more upper waveguide layers and not laterally flanked by the lateral cladding;
   an upper cladding above the active region; and
   a lower cladding below the one or more lower waveguide layers;
   wherein the upper cladding, the lower cladding, and lateral cladding sufficiently confine a fundamental mode of the light to generate a lasing light at a specific wavelength; and
   wherein the one or more lower waveguide layers cause higher-order modes of the light to leak past the lateral cladding and at least partially contribute to the high-order modes not reaching a lasing threshold.
17. The single-mode laser of item 16, wherein a lateral width between the lateral cladding is greater than 150% of the specific wavelength of the lasing light.
18. The single-mode laser of item 16, wherein the lateral width between the lateral cladding is between 200% and 300% of the specific wavelength of the lasing light.
19. The single-mode laser of item 16, comprising a diffraction grating configured to reflect light of the specific wavelength toward the active region.
20. The single-mode laser of item 1, wherein the one or more upper waveguide layers and the one or more lower waveguide layers comprise different quantities of waveguide layers.

The present disclosure includes reference to certain examples, however, it will be understood by those skilled in the art that various changes may be made and equivalents may be substituted without departing from the scope of the disclosure. In addition, modifications may be made to the disclosed examples without departing from the scope of the present disclosure. Therefore, it is intended that the present disclosure is not limited to the examples disclosed, but that the disclosure includes all examples falling within the scope of the appended claims.

## Claims

1. A single-mode laser, comprising:
a mesa comprising an active region and a first upper waveguide layer;
lateral cladding that flanks the active region and the first upper waveguide layer;
a first lower waveguide layer that laterally extends under the lateral cladding;
an upper cladding above the mesa; and
a lower cladding below the mesa and the first lower waveguide layer;
wherein the active region is configured to emit light in response to an electrical current;
wherein the upper cladding, the lower cladding, and lateral cladding sufficiently confine a fundamental mode of the light to reach a lasing threshold and generate a lasing light; and
wherein the first lower waveguide layer causes higher-order modes of the light to leak past the lateral cladding and at least partially contributes to the higher-order modes not reaching the lasing threshold.

2. The single-mode laser of claim 1, wherein a lateral width of the mesa between the lateral cladding is greater than a wavelength of the lasing light.

3. The single-mode laser of claim 2, wherein
a) the lateral width of the mesa is greater than 2.5 µm, and/or
b) the lateral width of the mesa is greater than 3 µm.

4. The single-mode laser of claim 2 or 3, wherein
a) the lateral width of the mesa is greater than 4 µm, and/or
b) the lateral width of the mesa is greater than 5 µm.

5. The single-mode laser of any one of claims 2 to 4, wherein
a) the lateral width of the mesa is greater than 150% of the wavelength of the lasing light, and/or
b) the lateral width of the mesa is greater than 200% of the wavelength of the lasing light.

6. The single-mode laser of any one of claims 2 to 5, wherein
a) the lateral width of the mesa is greater than 250% of the wavelength of the lasing light, and/or
b) the lateral width of the mesa is greater than 300% of the wavelength of the lasing light.

7. The single-mode laser of any one of the preceding claims, comprising a diffraction grating configured to reflect light of a specific wavelength toward the active region.

8. The single-mode laser of any one of the preceding claims, wherein the mesa includes a second upper waveguide layer.

9. The single-mode laser of claim 8, wherein a thickness of the first upper waveguide layer differs from a thickness of the second upper waveguide layer.

10. The single-mode laser of any one of the preceding claims, comprising
a second lower waveguide layer that laterally extends under the lateral cladding; and
wherein the second lower waveguide layer causes higher-order modes of the light to leak past the lateral cladding and at least partially contributes to the higher-order modes not reaching the lasing threshold.

11. The single-mode laser of claim 10, wherein a thickness of the first lower waveguide layer differs from a thickness of the second lower waveguide layers.

12. The single-mode laser of any one of the preceding claims, comprising multiple upper waveguide layers and multiple lower waveguide layers, wherein the upper waveguide layers and the lower waveguide layers comprise different quantities of waveguide layers.

13. The single-mode laser of any one of the preceding claims, wherein the lateral cladding does not flank the first lower waveguide layer and/or the multiple lower waveguide layers.

14. A single-mode laser, comprising:
an active region configured to emit light in response to an electrical current;
one or more upper waveguide layers;
lateral cladding that flanks the active region and the one or more upper waveguide layers;
one or more lower waveguide layers below the one or more upper waveguide layers and not laterally flanked by the lateral cladding;
an upper cladding above the active region; and
a lower cladding below the one or more lower waveguide layers;
wherein the upper cladding, the lower cladding, and lateral cladding sufficiently confine a fundamental mode of the light to generate a lasing light at a specific wavelength; and
wherein the one or more lower waveguide layers cause higher-order modes of the light to leak past the lateral cladding and at least partially contribute to the higher-order modes not reaching a lasing threshold.

15. The single-mode laser of claim 14,
a) wherein a lateral width between the lateral cladding is greater than 150% of the specific wavelength of the lasing light, and/or
b) comprising a diffraction grating configured to reflect light of the specific wavelength toward the active region, and/or
c) wherein the one or more upper waveguide layers and the one or more lower waveguide layers comprise different quantities of waveguide layers, and/or
d) wherein the lateral width between the lateral cladding is between 200% and 300% of the specific wavelength of the lasing light.
